# EUROPEAN PATENT APPLICATION

(11) **EP 1 816 748 A1**
(43) Date of publication of application: **08.08.2007**
(21) Application number: 07001984.9
(22) Date of filing: 30.01.2007
(51) Int. Cl.: H03L 7/081, H04L 7/033, H03L 7/091

(54) **Phase control circuit**

(30) Priority: 03.02.2006 JP 2006026667
(71) Applicant: Yokogawa Electric Corporation, Tokyo 180-8750 (JP)
(72) Inventor: Uchida, Kenji, Musashino-shi Tokyo 180-8750 (JP); Miura, Akira, Musashino-shi Tokyo 180-8750 (JP); Kodaka, Hirotoshi, Musashino-shi Tokyo 180-8750 (JP); Yakihara, Tsuyoshi, Musashino-shi Tokyo 180-8750 (JP); Tanimura, Daisuke, Musashino-shi Tokyo 180-8750 (JP); Tezuka, Kentaro, Musashino-shi Tokyo 180-8750 (JP); Butatsu, Kentaro, Musashino-shi Tokyo 180-8750 (JP)
(74) Representative: Grünecker, Kinkeldey, Stockmair & Schwanhäusser Anwaltssozietät

(57) **Abstract**

A phase control circuit includes: a variable delay circuit (6) for delaying a clock signal (101); a first flip-flop circuit (2) having a clock input terminal to which the delayed clock signal (101a) is input and a data input terminal to which a data signal (100) is input; a second flip-flop circuit (7) having a clock input terminal to which the data signal (100) is input and a data input terminal to which the delayed clock signal (101a) is input; and an integration circuit (50) for controlling a delay amount of the variable delay circuit based on an output signal of the second flip-flop circuit (7).

## Description

This application claims foreign priority based on Japanese Patent application No. 2006-026667, filed February 3,2006, the content of which is incorporated herein by reference in its entirety.

### BACKGROUND OF THE INVENTION

### 1. Field of the Invention

The present invention relates to a phase control circuit, and more particularly, to a phase control circuit which enables adjustment of an optimal timing regardless of changes over time or changes in temperature.

### 2. Description of the Related Art

Related arts of the phase control circuit are JP-A-2-202115, JP-A-5-199088 and JP-A-2001-111393, for example.

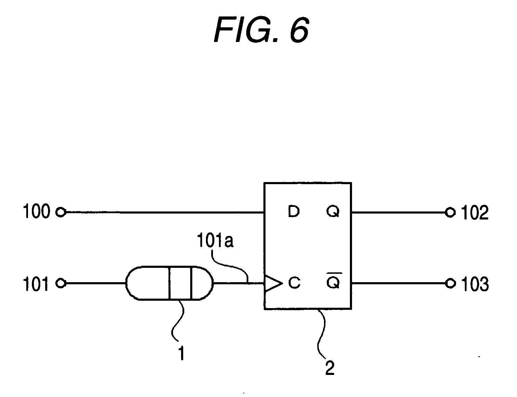

Fig. 6 is a block diagram showing an example of such a related-artphase control circuit. In Fig. 6, reference numeral 1 designates a delay circuit; and reference numeral 2 designates a flip-flop circuit. Reference numeral 100 designates a data signal; reference numeral 101 designates a clock signal; reference numeral 101a designates a clock signal delayed by the delay circuit 1; reference numeral 102 designates a noninverted output signal; and reference numeral 103 designates an inverted output signal.

The data signal 100 is transmitted to a data input terminal of the flip-flop circuit 2. The clock signal 101 is transmitted to an input terminal of the delay circuit 1, andanoutput terminal of the delay circuit 1 is connected to a clock input terminal of the flip-flop circuit 2. The noninverted output signal 102 is output from a noninverted output terminal of the flip-flop circuit 2, and the inverted output signal 103 is output from an inverted output terminal of the flip-flop circuit 2.

Operation of the example of the related-art flip-flop circuit 2 shown in Fig. 6 will now be described. The data signal 100 is an NRZ (Non Return to Zero) signal, and the flip-flop circuit 2 operates at a rising edge of a clock input signal.

It is assumed that the delay circuit 1 is eliminated from Fig. 6 and that the clock signal 101 is transmitted directly to the clock input terminal of the flip-flop circuit 2. In this case, for instance, in the flip-flop circuit 2, when a timing when the data signal 100 that is input to the data input terminal changes coincides with a timing of the rising edge of the clock signal 101 that is input to the clock input terminal, an output becomes uncertain.

Specifically, when a setup time or a hold time of the data signal 100 is not satisfied with respect to the rising edge of the clock signal 101, an output from the flip-flop circuit 2 becomes uncertain. For this reason, even when the data signal 100 is synchronized with the clock signal 101, adjustment of the timings is required.

As long as the delay circuit is used for either the data signal 100 or the clock signal 101, timings can be adjusted. However, since the band of the data signal is broader than the band of a clock signal in most cases, a delay circuit is usually used for the clock signal. Fig. 6 shows a case where the delay circuit 1 is used for the clock signal 101.

As a result, by providing the delay circuit 1 for the clock signal 101 that is input to the clock input terminal of the flip-flop circuit 2, the timing of a change in the data signal 100 that is input to the data input terminal of the flip-flop circuit 2 and the timing of the rising edge of the clock signal 101a that is input to the clock input terminal are optimized, and hence a stable output signal can be output.

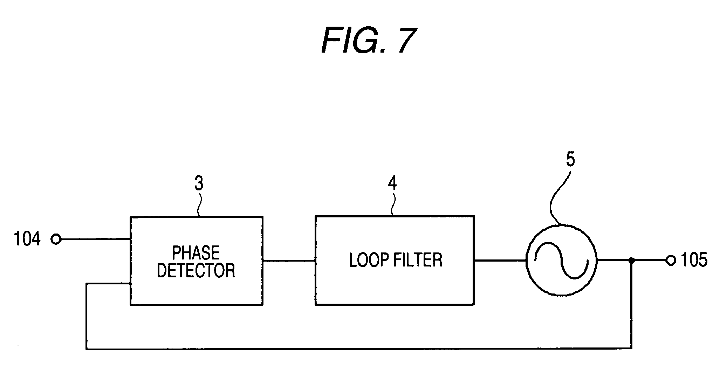

Fig. 7 is a block diagram showing another example of such a related-art phase control circuit. In Fig. 7, reference numeral 3 designates a phase detector; reference numeral 4 designates a loop filter; reference numeral 5 designates an oscillator; reference numeral 104 designates a reference signal; and reference numeral 105 designates an output signal.

A reference signal is input to one input terminal of the phase detector 3, and an output terminal of the phase detector 3 is connected to an input terminal of the loop filter 4. An output terminal of the loop filter 4 is connected to an input terminal of the oscillator 5. The output signal 105 is output from an output terminal of the oscillator 5, and the output terminal is connected to the other input terminal of the phase detector 3.

Operation of the related-art phase control circuit shown in Fig. 7 will now be described. The circuit shown in Fig. 7 is generally called a PLL (Phase-Locked Loop) and outputs, as the output signal 105, a signal having a frequency accurately synchronized with the reference signal 104.

Specifically, the phase detector 3 detects a phase difference between the reference signal 104 that is input from the external and the output signal 105 which is the output of the oscillator 5. The loop filter 4 converts a result of detection into a control voltage for the oscillator 5 to thus perform automatic control so that the phase difference becomes constant.

Consequently, the phase detector 3 detects a phase difference between the reference signal 104 and the output signal 105 of the oscillator 5, and the loop filter 4 converts a result of detection into a control voltage for the oscillator 5 to thus perform automatic control so that the phase difference becomes constant. As a result, a signal whose frequency is accurately synchronized with the reference signal 104 can be output as the output signal 105.

However, in the related-art example shown in Fig. 6, even if the timing of the data signal 100 and the timing of the clock signal 101 can be adjusted under conditions of a surrounding environment at a specific point in time such as at a time of manufacturing and shipment, there arises a problem that the timing becomes gradually unadjusted, because of a difference between a path of the data signal 100 and a path of the clock signal 101 or characteristics of the delay circuit 1 itself, in accordance with a change in service temperature environment or changes over time.

In the related-art example shown in Fig. 7, control can be performed in such a way that the phase difference between the reference signal 104 and the output signal 105 from the oscillator 5 becomes constant. However, there has been no circuit of a simple configuration that can match the timing of the data signal with the timing of the clock signal in the flip-flop circuit by utilizing this PLL technique.

### SUMMARY OF THE INVENTION

The present invention has been made in view of the above circumstances, and provides a phase control circuit which enables adjustment of optimal timings at all times, regardless to changes over time or temperature changes.

In some implementations, a phase control circuit of the invention, comprising:
a variable delay circuit for delaying a clock signal;
a first flip-flop circuit having a clock input terminal to which the delayed clock signal is input and a data input terminal to which a data signal is input;
a second flip-flop circuit having a clock input terminal to which the data signal is input and a data input terminal to which the delayed clock signal is input; and
an integration circuit for controlling a delay amount of the variable delay circuit based on an output signal of the second flip-flop circuit.

Accordingly, the adjustment to obtain the optimal timing is available at all times regardless to changes over time or temperature changes.

In the phase control circuit, the variable delay circuit changes the delay amount in accordance with a magnitude of the output signal of the integration circuit. Accordingly, the adjustment to obtain the optimal timing is available at all times regardless to changes over time or temperature changes.

In the phase control circuit, the integration circuit includes:
a first resistor of which one end is connected to a noninverted output terminal of the second flip-flop circuit;
a first capacitor of which one end is connected to the other end of the first resistor;
a second resistor of which one end is connected to an inverted output terminal of the second flip-flop circuit;
a second capacitor of which one end is connected to the other end of the second resistor and of which other end is connected to ground; and
an amplifier having an inverted input terminal connected to the other end of the first resistor and the one end of the first capacitor, a noninverted input terminal connected to the other end of the second resistor and the one end of the second capacitor, and an output terminal connected to the other end of the first capacitor and a control terminal of the variable delay circuit.

Accordingly, the adjustment to obtain the optimal timing is available at all times regardless to changes over time or temperature changes.

According to the phase control circuit, the integration circuit integrates outputs from the second flip-flop circuit having the clock input terminal to which the data signal is input and the data input terminal to which the clock signal is input. Then, the variable delay circuit is controlled based on the output resulting from integration. Thus, the timing of the clock signal is optimized. Accordingly, realization of a phase control circuit capable of adjustment to obtain the optimum timing at all times regardless to changes over time or temperature changes becomes feasible.

In some implementations, a phase control circuit of the invention, comprising:
a variable delay circuit for delaying a clock signal;
a first flip-flop circuit having a clock input terminal to which the delayed clock signal is input and a data input terminal to which a data signal is input;
a second flip-flop circuit having a clock input terminal to which the data signal is input and a data input terminal to which the delayed clock signal is input; and
an integration circuit for controlling a delay amount of the variable delay circuit by a mechanical driving force based on an output signal of the second flip-flop circuit.

Accordingly, the adjustment to obtain the optimal timing is available at all times regardless to changes over time or temperature changes.

In the phase control circuit, the variable delay circuit changes the delay amount in accordance with the mechanical driving force from the integration circuit. Accordingly, the adjustment to obtain the optimal timing is available at all times regardless to changes over time or temperature changes.

In the phase control circuit, the integration circuit includes:
a motor; and
a motor driving circuit for driving the motor by controlling a rotating direction of the motor in accordance with a logical level of the output signal of the second flip-flop circuit.

Accordingly, the adjustment to obtain the optimal timing is available at all times regardless to changes over time or temperature changes.

According to the phase control circuit, the integration circuit converts, into the mechanical driving force, the outputs from the second flip-flop circuit having the clock input terminal to which the data signal is input and the data input terminal to which the clock signal is input. Then, the variable delay circuit is controlled based on the driving force, whereby the timing of the clock signal is optimized. Accordingly, realization of a phase control circuit capable of adjustment to obtain the optimal timing at all times regardless to changes over time or temperature changes becomes feasible.

### BRIEF DESCRIPTION OF THE DRAWINGS

Fig. 1 is a configuration block diagram showing an embodiment of a phase control circuit of the present invention;
Fig. 2 is a timing chart showing an operation timing of a flip-flop circuit;
Fig. 3 is a timing chart showing operation timings of flip-flop circuits;
Fig. 4 is a timing chart showing operation timings of flip-flop circuits;
Fig. 5 is a configuration block diagram showing another embodiment of a phase control circuit of the present invention;
Fig. 6 is a configuration block diagram showing an example of a related-art phase control circuit; and
Fig. 7 is a configuration block diagram showing another example of the related-art phase control circuit.

### DESCRIPTION OF THE PREFERRED EMBODIMENTS

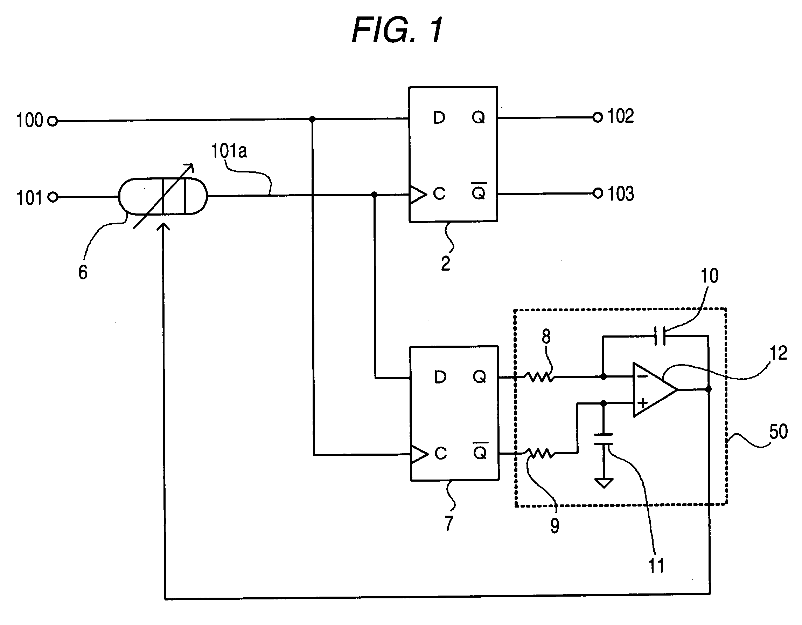

The present invention will be described in detail hereinbelow by reference to the drawings. Fig. 1 is a configuration block diagram showing an embodiment of a phase control circuit according to the present invention. In Fig. 1, reference numerals 2, 100, 101, 101a, 102, and 103 are the same as those shown in Fig. 6. Reference numeral 6 designates a variable delay circuit; reference numeral 7 designates a flip-flop circuit; reference numerals 8 and 9 designate resistors; reference numerals 10 and 11 designate capacitors; and reference numeral 12 designates an amplifier.

An integration circuit 50 includes the resistors 8 and 9, the capacitors 10 and 11, and the amplifier 12.

The data signal 100 is transmitted to a data input terminal of the flip-flop circuit 2 and a clock input terminal of the flip-flop circuit 7. The clock signal 101 is transmitted to an input terminal of the variable delay circuit 6, and an output terminal of the variable-delay circuit 6 is connected to a clock input terminal of the flip-flop circuit 2 and a data input terminal of the flip-flop circuit 7.

A noninverted output terminal of the flip-flop circuit 7 is connected to one end of the resistor 8, and the other end of the resistor 8 is connected to one end of the capacitor 10 and an inverted input terminal of the amplifier 12. An inverted output terminal of the flip-flop circuit 7 is connected to one end of the resistor 9, and the other end of the resistor 9 is connected to one end of the capacitor 11 and a noninverted input terminal of the amplifier 12.

The other end of the capacitor 11 is connected to ground, and an output terminal of the amplifier 12 is connected to a control terminal of the variable delay circuit 6 and the other end of the capacitor 10. The noninverted output signal 102 is output from the noninverted output terminal of the flip-flop circuit 2, and the inverted output signal 103 is output from an inverted output terminal of the flip-flop circuit 2.

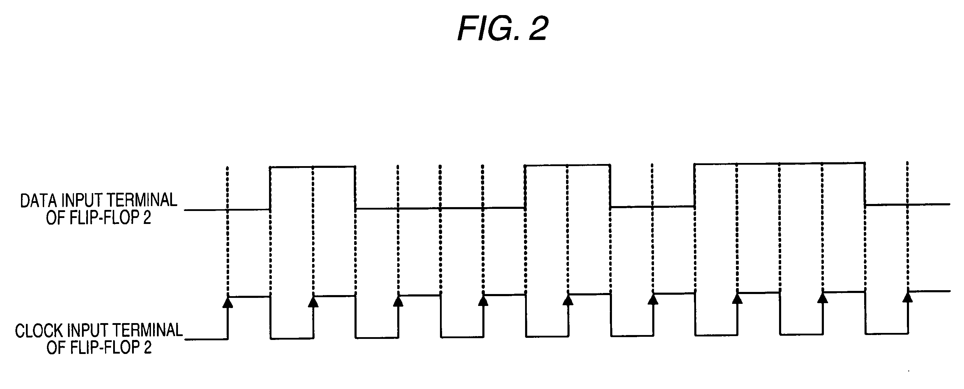

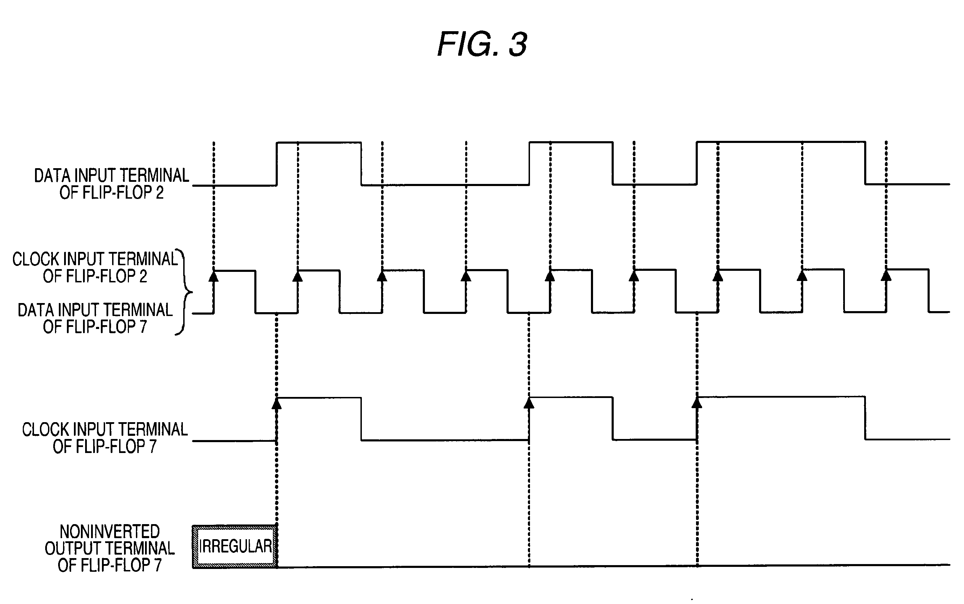

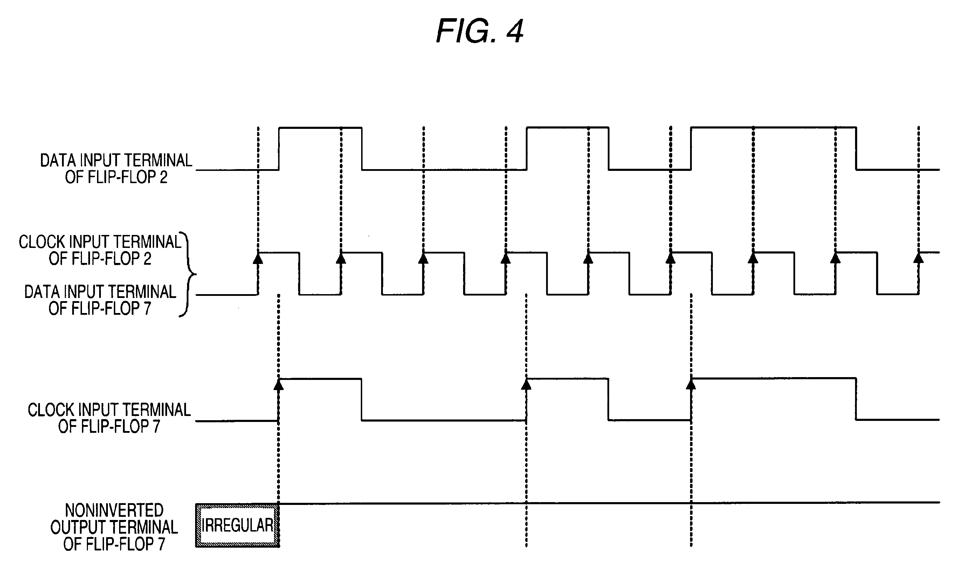

Operation of the phase control circuit of the present embodiment shown in Fig. 1 will be described by reference to Figs. 2, 3, and 4. Fig. 2 is a timing chart showing an operation timing of the flip-flop circuit 2, and Figs. 3 and 4 are timing charts showing the operation timing of the flip-flop circuit 2 and that of the flip-flop circuit 7.

Fig. 2 shows a timing chart achieved when the timing of data input and the timing of a clock signal input to the flip-flop circuit 2 are optimal. Specifically, the timing of a rising edge of the clock signal 101a does not coincide with the timing of change in the data signal 100 but the timing comes when the data signal is stable.

Fig. 3 shows a timing chart achieved when the timing of data input to the flip-flop circuit 2 is ahead of the optimal timing. As shown in Fig. 3, the noninverted output signal of the flip-flop circuit 7 becomes constantly at a low level except an initial unstable period, whereas the inverted output signal becomes constantly at a high level except the initial unstable period.

When the noninverted output signal and the inverted output signal from the flip-flop circuit 7 are input to the integration circuit 50, the output signal from the integration circuit 50 gradually becomes large.

It is assumed that as a characteristic of the variable delay circuit 6, the delay amount changes in accordance with the magnitude of a control signal that is input to a control terminal of the variable delay circuit. Specifically, when the control signal is large, the delay amount becomes larger. In contrast, when the control signal is small, the delay amount becomes smaller.

When the output signal from the integration circuit 50 gradually becomes larger, the delay amount of the variable delay circuit 6 gradually becomes larger correspondingly. Then, the clock signal 101a having been input ahead of the optimal timing approaches the optimal timing.

Fig. 4 shows a timing chart achieved when the timing of data input to the flip-flop circuit 2 is behind the optimal timing. As shown in Fig. 4, the noninverted output signal from the flip-flop circuit 7 becomes constantly at a high level except the initial unstable period, and the inverted output signal becomes constantly at a low level except the initial unstable period.

When the noninverted output signal and the inverted output signal from the flip-flop circuit 7 are input to the integration circuit 50, the signal output from the integration circuit 50 gradually becomes small.

When the signal output from the integration circuit 50 gradually becomes smaller, the delay amount of the variable delay circuit 6 gradually becomes smaller correspondingly. Then, the clock signal 101a having been input behind the optimal timing approaches the optimal timing.

Consequently, the integration circuit 50 integrates outputs from the flip-flop circuit 7 having the clock input terminal to which the data signal 100 is input and the data input terminal to which the clock signal 101a is input. Then, the variable delay circuit 6 is controlled based on the integrated output, whereby the timing of the clock signal 101 is optimized. Accordingly, the adjustment to obtain the optimal timing is available at all times regardless to changes over time or temperature changes.

In the embodiment shown in Fig. 1, the integration circuit 50 is provided with a differential input configuration. However, providing the integration circuit with a differential input configuration is not always needed, and the integration circuit may also be provided with a single input configuration.

In the embodiment shown in Fig. 1, the integration circuit 50 is formed with electrical components. However, forming the integration circuit with the electrical components is not always necessary, and integration may also be performed by use of a mechanical component such as a motor.

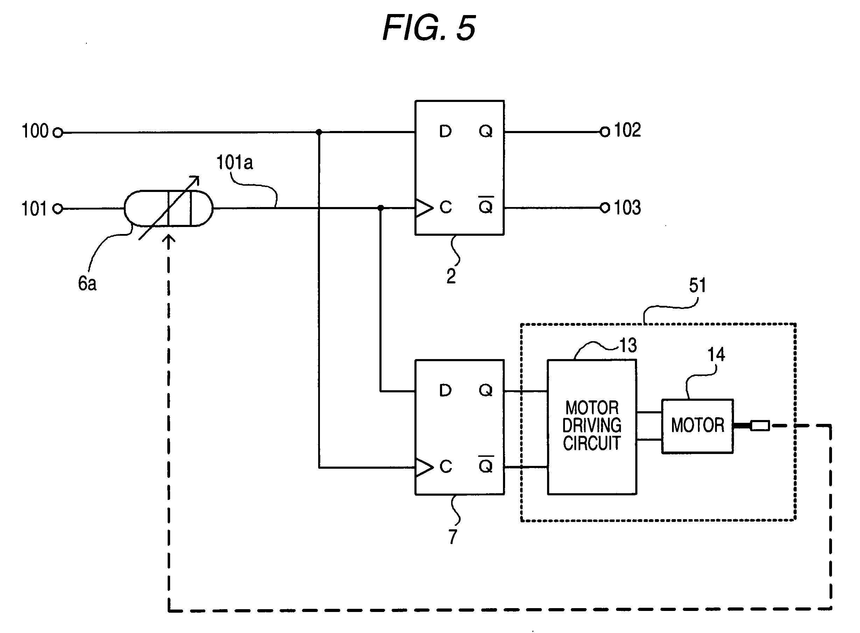

Operation of the phase control circuit performed in this case will be described by reference to Fig. 5. Fig. 5 is a configuration block diagram showing another embodiment of the phase control circuit of the present invention. In Fig. 5, reference numerals 2, 7, 100, 101, 101a, 102, and 103 are the same as those shown in Fig. 1. Reference numeral 6a designates a variable delay circuit; reference numeral 13 designates a motor driving circuit; and reference numeral 14 designates a motor. An integration circuit 51 includes the motor driving circuit 13 and the motor 14.

A noninverted output terminal of the flip-flop circuit 7 is connected to one input terminal of the motor driving circuit 13, and an inverted output terminal of the flip-flop circuit 7 is connected to the other input terminal of the motor driving circuit 13. One output terminal of the motor driving circuit 13 is connected to one input terminal of the motor 14, and the other output terminal of the motor driving circuit 13 is connected to the other input terminal of the motor 14.

A rotary portion of the motor 14 is connected to a delay control rotary switch of the variable delay circuit 6a. The other connections are the same as those shown in Fig. 1, and hence their explanations are omitted.

The basic operation of the phase control circuit is essentially identical with that of the phase control circuit according to the embodiment shown in Fig. 1. A difference between the basic operations of the phase control circuits lies in that the integration circuit 51 is formed with the motor driving circuit 13 and the motor 14, and that the variable delay circuit 6a is controlled by mechanical driving force.

As in the case of the embodiment shown in Fig. 1, when the timing of data input to the flip-flop circuit 2 is ahead of the optimal timing, the noninverted output signal of the flip-flop circuit 7 remains at a low level at all times except the initial unstable period, whereas the inverted output signal remains at a high level at all times except the initial unstable period.

During a period in which the noninverted output of the flip-flop circuit 7 remains at a low level and the inverted output of the flip-flop circuit remains at a high level, the motor driving circuit 13 rotates the motor 14 at a given speed in one direction. As a result, the delay control rotary switch of the variable delay circuit 6a is rotated, and the delay amount gradually becomes large. The clock signal 101a having been input ahead of the optimal timing approaches the optimal timing.

Likewise, when the timing of the data input to the flip-flop circuit 2 is behind the optimal timing, the noninverted output signal of the flip-flop circuit 7 remains at a high level at all times except the initial unstable period, whereas the inverted output signal of the same remains at a low level at all times except the initial unstable period.

During a period in which the noninverted output of the flip-flop circuit 7 is at a high level and the inverted output of the same is at a low level, the motor driving circuit 13 rotates the motor 14 at a given speed in reverse direction. As a result, the delay control rotary switch of the variable delay circuit 6a is rotated, and the delay amount gradually becomes small. The clock signal 101a having been input behind the optimal timing approaches the optimal timing.

Consequently, the data signal 100 is input to the clock input terminal, the integration circuit 51 converts, into mechanical rotation, outputs from the flip-flop circuit 7 having the data input terminal to which the clock signal 101a is input. Then, the variable delay circuit 6a is controlled based on the mechanical rotation. Thus, the timing of the clock signal 101 is optimized. Accordingly, the adjustment to obtain the optimal timing is available at all times regardless to changes over time or temperature changes.

In the embodiment shown in Fig. 5, the variable delay circuit 6a is controlled by the rotation generated by the integration circuit 51. However, rotation is not always needed, and the variable delay circuit 6a may be controlled by any mechanical driving force.

For instance, the rotation generated by the integration circuit 51 may be converted into horizontal sliding motion, and the delay amount of the variable delay circuit 6a may also be switched by a slide switch.

It will be apparent to those skilled in the art that various modifications and variations can be made to the described preferred embodiments of the present invention without departing from the spirit or scope of the invention. Thus, it is intended that the present invention cover all modifications and variations of this invention consistent with the scope of the appended claims and their equivalents.

## Claims

1. A phase control circuit, comprising:
a variable delay circuit for delaying a clock signal;
a first flip-flop circuit having a clock input terminal to which the delayed clock signal is input and a data input terminal to which a data signal is input;
a second flip-flop circuit having a clock input terminal to which the data signal is input and a data input terminal to which the delayed clock signal is input; and
an integration circuit for controlling a delay amount of the variable delay circuit based on an output signal of the second flip-flop circuit.

2. The phase control circuit according to claim 1, wherein the variable delay circuit changes the delay amount in accordance with a magnitude of the output signal of the integration circuit.

3. The phase control circuit according to claim 1, wherein the integration circuit includes:
a first resistor of which one end is connected to a noninverted output terminal of the second flip-flop circuit;
a first capacitor of which one end is connected to the other end of the first resistor;
a second resistor of which one end is connected to an inverted output terminal of the second flip-flop circuit;
a second capacitor of which one end is connected to the other end of the second resistor and of which other end is connected to ground; and
an amplifier having an inverted input terminal connected to the other end of the first resistor and the one end of the first capacitor, a noninverted input terminal connected to the other end of the second resistor and the one end of the second capacitor, and an output terminal connected to the other end of the first capacitor and a control terminal of the variable delay circuit.

4. The phase control circuit according to claim 2, wherein the integration circuit includes:
a first resistor of which one end is connected to a noninverted output terminal of the second flip-flop circuit;
a first capacitor of which one end is connected to the other end of the first resistor;
a second resistor of which one end is connected to an inverted output terminal of the second flip-flop circuit;
a second capacitor of which one end is connected to the other end of the second resistor and of which other end is connected to ground; and
an amplifier having an inverted input terminal connected to the other end of the first resistor and the one end of the first capacitor, a noninverted input terminal connected to the other end of the second resistor and the one end of the second capacitor, and an output terminal connected to the other end of the first capacitor and a control terminal of the variable delay circuit.

5. The phase control circuit according to claim 1, wherein the integration circuit controls the delay amount of the variable delay circuit by a mechanical driving force based on the output signal of the second flip-flop circuit.

6. The phase control circuit according to claim 5, wherein the variable delay circuit changes the delay amount in accordance with the mechanical driving force from the integration circuit.

7. The phase control circuit according to claim 5, wherein the integration circuit includes:
a motor; and
a motor driving circuit for driving the motor by controlling a rotating direction of the motor in accordance with a logical level of the output signal of the second flip-flop circuit.

8. The phase control circuit according to claim 6, wherein the integration circuit includes:
a motor; and
a motor driving circuit for driving the motor by controlling a rotating direction of the motor in accordance with a logical level of the output signal of the second flip-flop circuit.
